# EUROPÄISCHE PATENTANMELDUNG

(11) **EP 2 056 373 A1**
(43) Veröffentlichungstag der Anmeldung: **06.05.2009**
(21) Anmeldenummer: 07021158.6
(22) Anmeldetag: 30.10.2007
(51) Int. Cl.: H01L 51/54, C23C 14/56

(54) **Verfahren zur Bedampfung von bahnförmigen Materialien mit Fullerenen**

(71) Anmelder: Hueck Folien Ges.m.b.H., 4342 Baumgartenberg (AT); Plastic electronic GmbH, 4040 Linz (AT)
(72) Erfinder: Montaigne, Alberto, 4020 Linz (AT); Marjanovic, Nenad, 4040 Linz (AT); Tanda, Andreas, 4020 Linz (AT); Schmidegg, Klaus, 4040 Linz (AT); Bergsmann, Martin, 4020 Linz (AT)
(74) Vertreter: Landgraf, Elvira

(57) **Zusammenfassung**

Die Erfindung betrifft ein Verfahren zur Bedampfung von bahnförmigen Trägersubstraten mit Fullerenen, das dadurch gekennzeichnet ist, dass die Fullerene aus Schiffchen mit einer Aufdampfrate vom 0,1 - 150 nm/s in einer Vakuumbeschichtungsanlage auf das zu bedampfende bahnförmige Trägersubstrat aufgedampft wird.

## Beschreibung

Die Erfindung betrifft ein Verfahren zur Bedampfung von bahnförmigen Materialien mit Fullerenen, sowie nach diesem Verfahren hergestellte Produkte insbesondere für polymerelektronische Anwendungen.

Für derartige Anwendungen ist es notwendig, geeignete Halbleiterschichten mit hohen Ladungsträgerbeweglichkeiten auf das Trägermaterial aufzubringen. Fullerene erweisen sich für diesen Anwendungszweck als vorteilhaft, da sie relativ hohe Ladungsträgerbeweglichkeiten aufweisen.

Allerdings konnten Fullerene bisher nur im Einzelsubstratverfahren im Labormaßstab hergestellt und aufgebracht werden.

Aus der Literatur sind Konzepte zur Herstellung von organischen Feldeffekttransistoren auf Basis von Fullerenschichten bekannt, die im Labormaßstab sehr gute Leistungsdaten aufgrund der hohen Elektronenbeweglichkeit der Halbleiterschicht aufweisen, beispielsweise aus Th. B. Singh et al., "High-mobility n-channel organic field effect transistors based on epitaxially grown C60 films", Organic Electronics 2 (2005), 105; Thomas D. Anthopoulos, Th. B. Singh, N. Marjanovic, N. Sariciftci, M. Cölle, Dago M. de Leeuw, A. Montaigne Ramil, and H. Sitter "High performance n-channel organic field-effect transistors and ring oscillators based on C60 fullerene films", Applied Physic Letters, Vol. 89, 213504, 2006; A.; Montaigne Ramil and H. Sitter, Th. B. Singh, N. Marjanovic, S. Günes, G. J. Matt and N. S. Sariciftci, A. Andreev, T. Haber and R. Resel "Influence of Film Growth Conditions on Carrier Mobility of Hot Wall Epitaxially Grown Fullerene based Transistors", Journal of Crystal Growth, Vol. 288, 123-127,2006.

Aufgabe der Erfindung war es daher, ein Verfahren zur Bedampfung von bahnförmigen Materialien mit Fullerenen bereitzustellen.

Gegenstand der Erfindung ist daher ein Verfahren zur Bedampfung von bahnförmigen Trägersubstraten mit Fullerenen, das dadurch gekennzeichnet ist, dass die Fullerene aus Schiffchen mit einer Aufdampfrate von 0,1 - 150 nm/s in einer Vakuumbeschichtungsanlage auf das zu bedampfende bahnförmige Trägersubstrat aufgedampft werden.

Als Trägersubstrat kommen beispielsweise Trägerfolien vorzugsweise flexible Kunststofffolien, beispielsweise aus PI, PP, MOPP, PE, PPS, PEEK, PEK, PEI, PSU, PAEK, LCP, PEN, PBT, PET, PA, PC, COC, POM, ABS, PVC, Fluorpolymeren wie PTFE und dergleichen in Frage. Die Trägerfolien weisen vorzugsweise eine Dicke von 5 - 700 µm, bevorzugt 5 - 200 µm, besonders bevorzugt 23 - 100 µm auf.

Ferner können als Trägersubstrat auch Metallfolien, beispielsweise Al-, Cu-, Sn-, Ni-, Fe- oder Edelstahlfolien mit einer Dicke von 5 - 200 µm, vorzugsweise 10-80 µm, besonders bevorzugt 20 - 50 µm dienen. Die Folien können auch oberflächenbehandelt, beschichtet oder kaschiert, beispielsweise mit Kunststoffen, oder lackiert sein.

Ferner können als Trägersubstrate auch Verbunde mit Papier, beispielsweise Verbunde mit Kunststoffen mit einem Flächengewicht von 20 - 500 g/m², vorzugsweise 40 - 200 g/m² verwendet werden.

Die Trägersubstrate können zusätzlich eine Lackschicht aufweisen, die unstrukturiert oder strukturiert, beispielsweise geprägt, sein kann. Die Lackschicht kann beispielsweise eine releasefähige Transferlackschicht sein, sie kann durch Strahlung, beispielsweise UV-Strahlung vernetzt oder vernetzbar sein und kratzfest und/oder antistatisch ausgerüstet sein. Geeignet sind sowohl wässrige als auch feste Lacksysteme, insbesondere auch Lacksysteme auf Basis Polyester-Acrylat oder Epoxyacrylat Kolophonium-, Acrylat-, Alkyd-, Melamin-, PVA-, PVC-, Isocyanat-, Urethansysteme, die konventionell oder reaktiv härtend (chemisch oder strahlungshärtend) sein können.

Ferner kann das Trägersubstrat bereits eine oder mehrere Schichten, die durch Drucken oder Metallisieren erzeugt wurden aufweisen. Diese Schichten können strukturiert (partiell) oder vollflächig aufgebracht sein.

Auf dieses Trägersubstrat wird in einer herkömmlichen Vakuumbeschichtungsanlage eine Schicht oder mehrere Schichten aus Fullerenen aufgedampft.

Unter Fullerenen werden C₆₀, C₇₀, C₇₆, C₈₀, C₈₂, C₈₄, C₈₆, C₉₀, C₉₄ verstanden. Das zu bedampfende Trägersubstrat wird dabei mittels einer Wickeleinrichtung an der Verdampfereinrichtung vorbei transportiert.

Dabei werden die Fullerene aus speziellen Schiffchen mit einer Aufdampfrate von 0,1 bis 150 nm/s, vorzugsweise 5 - 100 nm/s verdampft.

Die Schiffchen sind dabei vorzugsweise geschlossenen Schiffchen mit Durchlassöffnungen, vorzugsweise mit Perforationen. Vorzugsweise bestehen die Schiffchen aus Mb, Ta, Quarz, Bornitrid oder ähnlichen Materialien.

Die Verdampfungsrate und die Schichtdicke werden dabei während des Prozesses kontinuierlich überwacht.

Dabei werden bei entsprechenden Bahngeschwindigkeiten Schichtdicken von bis zu mehreren hundert Nanometern, etwa 1 bis 500 nm, vorzugsweise 5 - 300 nm, besonders bevorzugt 5 bis 250 nm aufgebracht.

Die Struktur der Fullerene wird dabei beim Verdampfungsvorgang nicht zerstört. Dazu wird die Temperatur im Verdampfer exakt geregelt. Der Verdampfungsvorgang findet dabei bei einer Temperatur von 150 - 600°C, vorzugsweise 300 - 420°C statt.

Ferner wird die Verdampfung der Fullerene vorteilhafterweise bei einem Restgasdruck von 1.10⁻⁸ bis 1.10⁻¹ mbar, vorzugsweise 1.10⁻⁵ bis 5.10⁻⁴ mbar durchgeführt.

Gleichzeitig findet bei der Verdampfung der Fullerene eine Reduktion der in den Fullerenen vorhandenen Verunreinigungen statt, wobei die Verunreinigungen vorwiegend Lösungsmittelreste oder Verunreinigungen aus der Herstellung der Fullerene sind.

Dadurch weisen die Schichten eine hohe Reinheit auf, die für die Funktion von elektronischen Bauteilen wichtig ist.

Ferner können im selben Verfahrensschritt auch eine oder mehrere weitere Schichten, beispielsweise dielektrische Schichten oder Metallschichten aufgedampft werden.

Als dielektrische Schichten kommen beispielsweise oxidische Schichten wie SiOx, TiO₂, Al₂O₃, ZrO, ITO, ATO, FTO und dergleichen in Frage.

Als metallische Schichten kommen beispielsweise Schichten aus Kupfer, Aluminium, Silber, Gold, Eisen, Chrom und dergleichen in Frage.

Die durch das erfindungsgemäße Verfahren aufgebrachten Schichten aus Fullerenen zeigen halbleitende Eigenschaften mit Elektronenbeweglichkeiten von 0.01 - 10 cm²/Vs auf. Ferner weisen die Schichten eine homogene Schichtdicke und Morphologie auf.

Die mittels des erfindungsgemäßen Verfahrens hergestellten bahnförmigen Trägersubstrate können daher als aktive Materialien in elektronischen Bauelementen wie Dünnschichttransistoren, Dioden, Sensoren und dergleichen eingesetzt werden.

Gegenüber Trägersubstraten mit gedruckten Halbleitschichten weisen die Fullerenschichten eine höhere Homogenität und eine höhere Elektronenbeweglichkeit auf.

## Patentansprüche

1. Verfahren zur Bedampfung von bahnförmigen Trägersubstraten mit Fullerenen, das **dadurch gekennzeichnet ist, dass** die Fullerene aus Schiffchen mit einer Aufdampfrate vom 0,1 - 150 nm/s in einer Vakuumbeschichtungsanlage auf das zu bedampfende bahnförmige Trägersubstrat aufgedampft wird.

2. Verfahren nach Anspruch 1, **dadurch gekennzeichnet, dass** die Schiffchen im Wesentlichen geschlossene Schiffchen mit Durchlassöffnungen sind.

3. Verfahren nach einem der Ansprüche 1 oder 2, **dadurch gekennzeichnet, dass** die Verdampfung bei einer Temperatur von 150 bis 600°C erfolgt.

4. Verfahren nach einem der Ansprüche 1 bis 3, **dadurch gekennzeichnet, dass** die Verdampfung bei einem Restdruck von 1.10⁻⁸ bis 1.10⁻¹ mbar erfolgt.

5. Verfahren nach einem der Ansprüche 1 bis 4, **dadurch gekennzeichnet, dass** die aufgedampften Schichten eine Schichtdicke von 1 bis 500 nm aufweisen.

6. Verfahren nach einem der Ansprüche 1 bis 5, **dadurch gekennzeichnet, dass** anschließend dielektrische oder metallische Schichten aufgedampft werden.

7. Mit Fullerenen bedampfte Trägersubstrate hergestellt nach einem der Ansprüche 1 bis 6.

8. Verwendung der Trägersubstrate nach Anspruch 7 für elektronische Bauteile.

## Geänderte Patentansprüche

### Geänderte Patentansprüche gemäss Regel 137(2) EPÜ.

**1.** Verfahren zur Bedampfung von bahnförmigen Trägersubstraten mit Fullerenen, das **dadurch gekennzeichnet ist, dass** die Fullerene aus Schiffchen mit einer Aufdampfrate vom 0,1 - 150 nm/s, bei einer Temperatur von 300 - 420°C und bei einem Restdruck von 1.10⁻⁵ bis 1.10⁻⁴ mbar in einer Vakuumbeschichtungsanlage auf das zu bedampfende bahnförmige Trägersubstrat aufgedampft wird.

**2.** Verfahren nach Anspruch 1, **dadurch gekennzeichnet, dass** die Schiffchen im Wesentlichen geschlossene Schiffchen mit Durchlassöffnungen sind.

**3.** Verfahren nach einem der Ansprüche 1 bis 2, **dadurch gekennzeichnet, dass** die aufgedampften Schichten eine Schichtdicke von 1 bis 500 nm aufweisen.

**4.** Verfahren nach einem der Ansprüche 1 bis 3, **dadurch gekennzeichnet, dass** anschließend dielektrische oder metallische Schichten aufgedampft werden.

**5.** Mit Fullerenen bedampfte Trägersubstrate hergestellt nach einem der Ansprüche 1 bis 4.

**6.** Verwendung der Trägersubstrate nach Anspruch 5 für elektronische Bauteile.
